# EUROPEAN PATENT SPECIFICATION

(11) **EP 0 399 219 B1**
(45) Date of publication and mention of the grant of the patent: **05.02.1997**
(21) Application number: 90107621.6
(22) Date of filing: 23.04.1990
(51) Int. Cl.: B32B 17/04, B32B 5/26, B32B 15/14

(54) **Laminate**
Schichtstoff
Matériel déposé en couches

(30) Priority: 21.04.1989 JP 102913/89; 31.01.1990 JP 19184/89
(43) Date of publication of application: 28.11.1990
(73) Proprietor: NITTO BOSEKI CO., LTD., Fukushima-shi Fukushima (JP)
(72) Inventor: Matsui, Tetsuo, Fukushima-shi, Fukushima (JP); Yamaguchi, Shigeo, Fukushima-shi, Fukushima (JP); Sato, Tadashige, Fukushima-shi, Fukushima (JP)
(74) Representative: Füchsle, Klaus, Dipl.-Ing.

(56) References cited:
- EP-A- 0 050 855
- FR-A- 2 510 624
- US-A- 2 215 938
- US-A- 3 463 698
- US-A- 3 617 613
- US-A- 4 414 264

## Description

The present invention relates to a laminate for a substrate plate of a printed wiring board. Particularly the present invention relates to a laminate which is less prone to warpage and torsion than other known wiring boards. In the present invention, the laminate includes not only those comprising a woven fabric as a base material, but also those of composite type comprising a combination of a woven fabric with a non-woven fabric as a base material.

A laminate or a copper-clad laminate is manufactured by stacking a predetermined number of sheets of prepregs prepared by impregnating a base material with a resin and drying, and optionally superposing and pressing a copper foil on the surface thereof. In the application field of printed wiring boards, which is the main use of the copper-clad laminates, requirements on the performance of the printed wiring boards have become severer with the progress of automatic high-density mounting technique. As the result, decrease of warpage and torsion of the laminate as a substrate plate of printed wiring boards is eagerly desired.

The causes of the warpage and torsion arising in the laminate vary somewhat depending on the kind of laminate, manufacturing process, and the kind of starting materials. The causes are considered to exist in formation of stress and strain mainly in a substrate fabric, or woven and nonwoven fabrics as a stress bearer, resulting from:
(a) difference of tension between in warp direction and in weft direction in the manufacturing process.
(b) application of pressure with a pressing machine,
(c) flow of a matrix resin during pressing, and
(d) difference of expansion or shrinkage between the base material and the matrix resin, resulting from the difference of temperatures and the difference of linear expansion coefficients thereof. With conventional laminates, automatic machines for providing printed wiring boards sometimes have to be interrupted or are forced to be stopped because of such serious warpage and torsion.

The inventors of the present invention have found another cause of formation of warpage and torsion in addition to the known causes as below.

That is, if the fabric itself to be used for the base material involves the factors of generating internal stress and strain, the external stress and strain caused combinedly by the factors of (a) to (d) added to the internal stress and strain of the fabrics results in larger stress and strain, generating larger warpage and larger torsion of the laminate. Accordingly, a decrease of the internal stress and strain in the fabric itself is necessary in order to decrease the warpage and the torsion.

A specific prior art that is of interest is FR-A-2 510 624 that is concerned with a braided textile for providing reinforced layered articles, for example by impregnating a layer of said textile with an appropriate resin and then polymerising it to obtain a rigid sheet. This prior art teaches that for every S-twist yarn in the braid there must be a Z-twist yarn such that two such yarns together balance out torsion. This applies to both the weft and the warp yarns. Only if there are no twisted yarns in the warp is there no need to do any balancing for the warp yarns. The yarns may be of glass.

A further prior art of interest is US-A-3 617 613 that is concerned with a printed circuit board base laminate formed by laminating resin impregnated woven glass fiber sheets. It acknowledges that it is known to fabricate epoxy-impregnated woven fiber glass sheet laminates but points out that when holes are punched therethrough there is an excessive fraying of the woven fiber glass filaments resulting in an excessive pull out of fibers from the laminate adjacent the area of the punched holes. This problem is said to be solved by fabricating a core sheet with non-woven glass fibers held together with a suitable binder and laminating it to the epoxy-impregnated woven fiber glass sheet laminates. There is no disclosure as to whether or not the glass yarns employed are twisted yarns and hence there is no mention of any warpage problems that have to be solved.

The present invention is accomplished on the basis of the aforesaid known warpage and torsion problems and the findings of the inventors of the present invention.

An object of the present invention is to provide an improved laminate which is remarkably less subject to warpage and torsion as compared with those of the prior art.

According to one aspect of the present invention, there is provided a laminate for printed wiring boards comprising a plurality of woven fabric layers which are stacked and a synthetic resin impregnated into the woven fabric layers and integrating therewith the layers;
said fabric having glass fiber warp yarns and glass fiber weft yarns;
said yarns have a number of twists of from 0.3 to 3t/25 mm the weft yarns comprising solely Z-twist yarns or solely S-twist yarns; and
wherein when the weft glass fiber yarns comprise solely Z-twist yarns, the warp glass fiber yarns comprise S-twist yarns and Z-twist yarns in a ratio ranging from 1/2 to 1/8 distributed substantially uniformly, and when the weft glass fiber yarns comprise solely S-twist yarns, the warp glass fiber yarns comprise Z-twist yarns and S-twist yarns in a ratio ranging from 1/2 to 1/8 distributed substantially uniformly.

The invention is set out in Claim 1. Further features thereof are claimed in Claims 2-6.

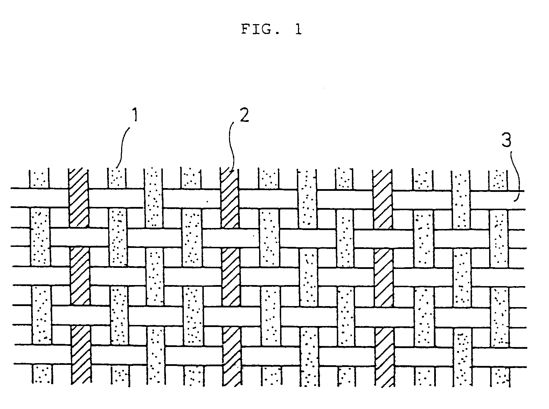

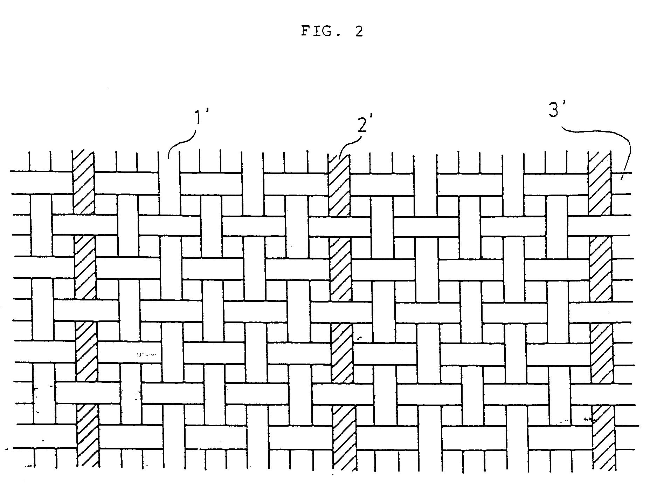

Fig. 1 and Fig. 2 illustrate the texture of the glass fiber fabric of the present invention. In the warp yarn of the present invention, the numbers of twists of the S-twist yarns and of the Z-twist yarns are preferably equal to each other.

As used hereinafter the term "single yarn fabric" means a fabric constituted of single twist yarns of soft twist (i.e., of small twist number) as the constituting yarns.

Fig. 1 illustrates a weave texture of a plain-weave glass fiber fabric. This fabric is constituted of warp yarns consisting of glass fiber single yarn ECG-75 1/0-1Z for warp yarn 1 and glass fiber single yarn ECG-75 1/0-1S for warp yarn 2 in a ratio of 3 to 1, and glass fiber single yarn ECG-75 1/0-0.7Z for weft yarn 3.

The yarn count of the yarns used for the glass fiber fabric is preferably in the range of from 5 to 150 in the tex indication. The shape, diameter, and the like of the filaments constituting the yarn are not specially limited, provided that the adhesion with the resin is not retarded. The number of twist of the yarns is from 0.3 to 3 t/25 mm. With a twist number of less than 0.3, the bundling property of the filaments constituting the yarn is not sufficient in that the workability is lowered at a weaving process, while with a twist number of more than 3, the yarn becomes a single twist yarn having a larg twist number having an impaired handling property.

In the constitution of the fabric, the thread count is from 20 to 80/25 mm, the mass of the textile fabric is from 20 to 400 g/m², and the type of weaving includes plain weave, satin weave, twill weave, and the like.

The fabric used for a base material of laminate may be treated with a variety of treating agents for improving adhesion to the matrix resin. The kind and the amount thereof are not limited specifically.

The uniformity of the woven fabric, and bowing of the warp yarn and weft yarn is not specially limited, but an improvement thereof will increase the effect of the present invention.

The laminate of the present invention has a thickness of from 0.1 to 3.0 mm, in which the effect of the present invention is most remarkably achieved.

The matrix resin for the laminate includes thermosetting resins such as epoxy resins, phenol resins, polyimide resins, unsaturated polyester resins, and silicone resins, and thermoplastic resins such as fluorine type resins. Two or more of these resins may be used in combination as the matrix resin.

The laminate of the present invention is prepared by treating the fabric of the above constitution with the matrix resin according to a known method to form a prepreg, forming a stack from a plurality of the prepreg sheets, optionally superposing a metal foil on the one or both faces of the stack, and hot-pressing it.

The composite type laminate of the present invention is prepared by employing the aforementioned woven fabric and nonwoven fabric in combination as the base material, impregnating the base material with the aforementioned resin to form a prepreg, forming a stack from a plurality of the prepreg sheets, and hot-pressing it.

Hitherto, bowing of weft yarn has been mentioned as one factor of causing warpage and torsion. The inventors of the present invention have found that the fabric itself has a cause of warpage and torsion. In case of glass fiber single yarn fabric, the yarn has been of a single twist yarn of soft twist, and distortion caused by deviation of the twist is kept restrained owing to a heat set effect during heat cleaning process and a set effect in the subsequent surface treatment. Further, the requirements against warpage and torsion were not so severe as those nowadays. Thus, the deviation of twist has presumably not been noticed.

The inventors of the present invention noticed the deviation of twist while studying improvements of the level of the warpage and torsion of laminates, and found the contribution of the warp yarn and weft yarn thereto. Thus alternate use of S-twist yarns and Z-twist yarns for avoiding the deviation of twist in the warp yarn direction is found to decrease the warpage and torsion of the laminate. However, the deviation in the weft yarn direction still remained unsatisfactory.

To solve this problem a fabric having glass fiber warp yarns and glass fiber weft yarns was used, said yarns having a number of twists of from 0.3 to 3t/25mm; with the weft yarns comprising solely Z-twist yarns or solely S-twist yarns. Additionally, in a first embodiment wherein the weft glass fiber yarns comprise solely Z-twist yarns, the warp glass fiber yarns comprise S-twist yarns and Z-twist yarns in a ratio ranging from 1/2 to 1/8 distributed substantially uniformly. In a second embodiment wherein the weft glass fiber yarns comprise solely S-twist yarns, the warp glass fiber yarns comprise Z-twist yarns and S-twist yarns in a ratio ranging from 1/2 to 1/8 distributed substantially uniformly. The range selected depends upon the kind of fabric, e.g. the type of warp yarn and weft yarn, the thread count, and the like.

### EXAMPLE

A glass fiber fabric was used as the base material for the laminate of the present invention.

The glass fiber fabric was woven by employing the method of the present invention and by using two kinds of WEA-18W type and WEA-19 type (both made by nitto Boseki Co., Ltd.), and subjected to heat cleaning and surface treatment according to a known method to obtain the glass fiber fabric shown in Table 1. For the comparison, usual WEA-18W and WEA-19 types employing only Z-twist yarns were used.

Prepreg sheets were prepared from each of four kinds of glass fiber fabrics and an epoxy resin (Type FR-4). Eight sheets of prepreg were stacked, and further a copper foil of 18 µm thick was superposed respectively on the uppermost face and the lowermost face of the stack. The resulting stack was pressed at a pressure of 80 kg/cm² at a temperature of 170°C for a pressing time of 90 minutes to give a copper-clad laminate.

The glass fiber fabric employed in this test was cut out into a long rectangular strip (10 × 200 cm). The torsion angle of the fabric was measured by hanging the fabric with the one end being fixed. The copper-clad laminate was subjected to measurement of warpage and torsion according to the test method specified in JIS C 6481 5.4.3. The results are shown in Table 1 and Table 2.

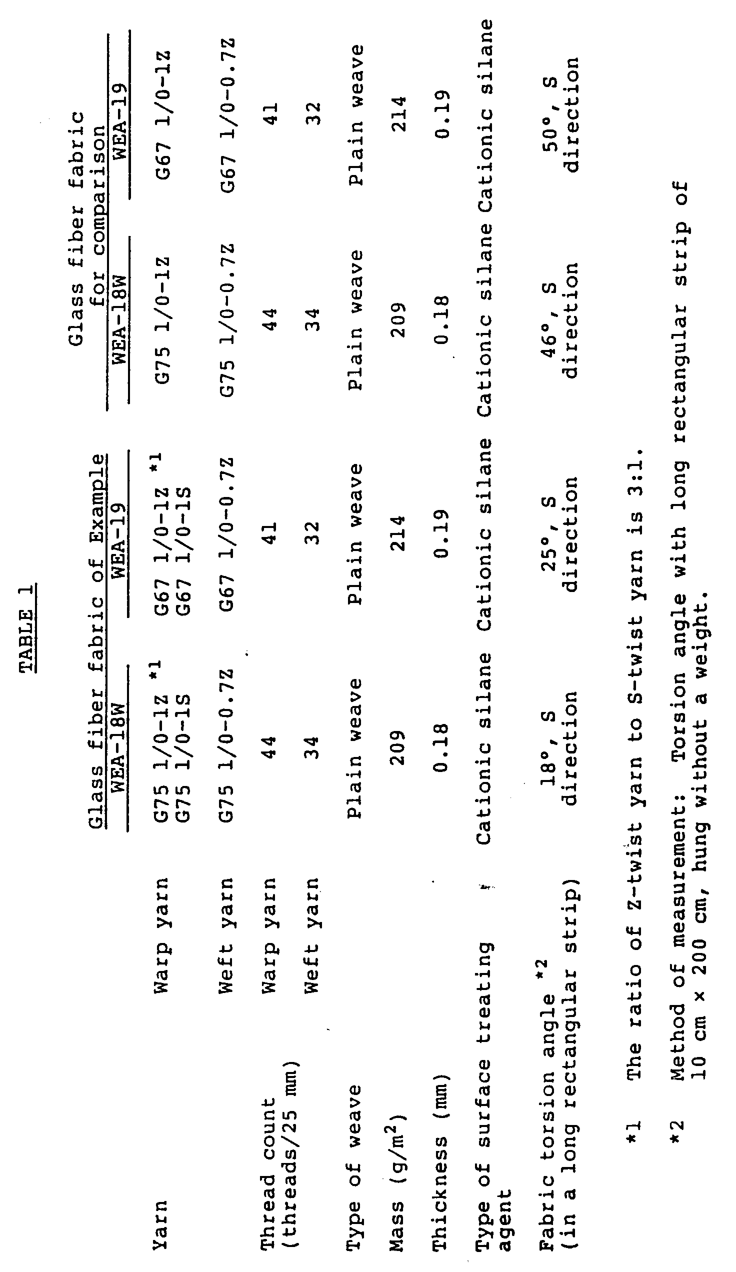

**TABLE 2**

| | | Example 1 WEA-18W | Example 1 WEA-19 | Comparative Example 1 WEA-18W | Comparative Example 1 WEA-19 |
|---|---|---|---|---|---|
| Warpage (mm) | Before heating | 1.0 | 1.0 | 2.0 | 2.5 |
| | After heating * | 1.5 | 2.0 | 3.5 | 3.5 |
| Torsion (mm) | Before heating | 5.5 | 5.0 | 10.5 | 10.0 |
| | After heating * | 7.0 | 7.0 | 14.5 | 15.5 |
| Method of measurement: JIS C 6481 5.4.3 Dimension of specimen: 450 mm × 450 mm, foiled with copper on both faces | | | | | |

| | | | | | |
|---|---|---|---|---|---|
| * Heating conditions: 170°C for 30 minutes | | | | | |

As shown clearly in Table 2, the copper-clad laminates of the present invention in Example 1 are confirmed to be remarkably reduced in warpage and torsion as compared with those of Comparative Example 1.

### EXAMPLE 2

A glass fiber fabric of so-called thin fabric (100 µm thick) was used as the base material for the laminate of the present invention.

The glass fiber fabric was woven by employing the method of the present invention and by using WEA-116E type (made by Nitto Boseki Co., Ltd.), and subjected to heat cleaning and surface treatment according to a known method to obtain a glass fiber fabric shown in Table 3. For the comparison, usual WEA-116E type employing only Z-twist yarns was used.

Prepreg sheets were prepared from each of two kinds of glass fiber fabrics and an epoxy resin (Type FR-4). Ten sheets of prepreg were stacked, and further a copper foil of 18 µm thick was superposed respectively on the uppermost face and the lowermost face of the stack. The resulting stack was pressed at a pressure of 80 kg/cm² at a temperature of 170°C for a pressing time of 90 minutes to give a copper-clad laminate.

The glass fiber fabric employed in this test was cut out into a long rectangular strip (10 × 200 cm). The torsion angle of the fabric was measured by hanging the fabric with the one end being fixed. The copper-clad laminate was subjected to measurement of warpage and torsion according to the test method specified in JIS C 6481 5.4.3. The results are shown in Table 3 and Table 4.

**TABLE 3**

| | | Glass fiber fabric of Example 2 | Glass fiber fabric for comparison |
|---|---|---|---|
| Yarn | Warp yarn | E-225 1/0-1Z *¹ | E-225 1/0-1Z |
| | | E-225 1/0-1S | |
| | Weft yarn | E-225 1/0-1Z | E-225 1/0-1Z |
| Thread count (threads/25 mm) | Warp yarn | 60 | 60 |
| | Weft yarn | 57 | 57 |
| Type of weave | | Plain weave | Plain weave |
| Mass (g/m²) | | 104 | 104 |
| Thickness (mm) | | 0.10 | 0.10 |
| Type of surface treating agent | | Cationic silane | Cationic silane |
| Fabric torsion angle *² (in a long rectangular strip) | | 0.5° | 20.0° |

| | | | |
|---|---|---|---|
| *1 The ratio of Z-twist yarn to S-twist yarn is 5:1. | | | |
| *2 Method of measurement: Torsion angle with a long rectangular strip of 10 cm × 200 cm, hung without a weight. | | | |

**TABLE 4**

| | | Example 2 WEA-116E | Comparative Example 2 WEA-116E |
|---|---|---|---|
| Warpage (mm) | Before heating | 1.0 | 2.5 |
| | After heating * | 1.5 | 3.0 |
| Torsion (mm) | Before heating | 4.5 | 7.0 |
| | After heating * | 5.0 | 8.5 |
| Method of measurement: JIS C 6481 5.4.3 Dimension of specimen: 450 mm × 450 mm, foiled with copper on both faces | | | |

| | | | |
|---|---|---|---|
| * Heating conditions: 170°C for 30 minutes | | | |

Fig. 2 illustrates the texture of the glass fiber fabric of this Example. This is a plain weave fabric which is constituted of warp yarns consisting of glass fiber single yarn ECE 225 1/0-1Z for warp yarn 1' and glass fiber single yarn ECE 225 1/0-1S for warp yarn 2' in a ratio of 5:1, and glass fiber single yarn ECE 225 1/0-1Z for weft yarn 3'.

### EXAMPLE 3

A laminate (which is usually called a composite type laminate) was prepared by employing a glass fiber fabric of WEA-18W type among the glass fiber fabrics used in Example 1 and Comparative Example 1, and a glass paper (i.e., a nonwoven glass fabric) in combination according to a known method. The procedure of preparation was as below. A glass fiber prepreg sheet was prepared from a glass paper of 100 g/m² and an epoxy resin (Type FR-4) in a resin content of 67%. On the other hand, a glass fiber fabric prepreg sheet was prepared from a glass fiber fabric of 209 g/m² and an epoxy resin (Type FR-4) in a resin content of 42%. Four sheets of the glass paper prepreg were stacked, and one sheet of the glass fiber fabric prepreg was placed respectively on the uppermost face and the lowermost face of the stack. Further a copper foil of 18 µm thick was superposed respectively on the both faces thereof. The resulting stack was pressed at a pressure of 30 kg/cm² at a temperature of 170°C for 90 minutes. Thus two kinds of laminates (composite type laminates) were prepared, which had a dimension of 45 cm × 45 cm and 1.6 mm thick.

These laminates of Example 3 according to the present invention and Comparative Example 3 thereof were tested for warpage and torsion in the same manner as in Example 1. Table 5 shows the results.

**TABLE 5**

| | | Example 3 | Comparative Example 3 |
|---|---|---|---|
| Warpage (mm) | Before heating | 2.0 | 4.0 |
| | After heating * | 3.5 | 5.5 |
| Torsion (mm) | Before heating | 6.0 | 12.5 |
| | After heating * | 10.5 | 22.0 |
| Dimension of specimen: 450 mm × 450 mm, foiled with copper on both faces | | | |

| | | | |
|---|---|---|---|
| * Heating conditions: 170°C for 30 minutes after press-molding | | | |

As clearly shown in Table 5, the composite type laminate of Example 3 is confirmed also to be remarkably less in warpage and torsion in comparison with the conventional composite type laminate of Comparative Example 3.

In the present invention, the internal stress in the base woven fabric itself is decreased by Z-twist yarns and S-twist yarns arranged in a specified ratio in the warp yarn. The laminates prepared by employing such a base woven fabric are remarkably less in warpage and torsion as compared with the conventional laminates. As the result, the laminates of the present invention, in particular, in use for printed wiring boards, can be treated by an automatic high-density mounting apparatus without troubles.

## Claims

1. A laminate for printed wiring boards comprising a plurality of woven fabric layers which are stacked and a synthetic resin impregnated into the woven fabric layers and integrating therewith the layers;
said fabric having glass fiber warp yarns and glass fiber weft yarns;
**characterized in that**
said yarns have a number of twists of from 0.3 to 3t/25 mm; the weft yarns comprise solely Z-twist yarns or solely S-twist yarns; and
wherein when the weft glass fiber yarns comprise solely Z-twist yarns, the warp glass fiber yarns comprise S-twist yarns and Z-twist yarns in a ratio ranging from 1/2 to 1/8 distributed substantially uniformly, and when the weft glass fiber yarns comprise solely S-twist yarns, the warp glass fiber yarns comprise Z-twist yarns and S-twist yarns in a ratio ranging from 1/2 to 1/8 distributed substantially uniformly.

2. A laminate according to Claim 1, wherein the twist numbers of the Z-twist yarns and of the S-twist yarns constituting the warp yarn are equal to each other.

3. A laminate according to Claim 1 wherein a copper foil is adhered to one or both faces of the laminate.

4. A laminate as in Claim 1 additionally comprising a plurality of non-woven fabric layers which are stacked whereby at least two of said woven fabric layers are provided, one of which is stacked on one face of the stacked non-woven fabric layers and the other of which is stacked on the other face of the non-woven fabric layers; and wherein a synthetic resin is impregnated into both the non-woven fabric layers and the woven fabric layers thereby integrating these layers.

5. A laminate according to Claim 4 wherein the twist numbers of the Z-twist yarns and of the S-twist yarns constituting the warp yarns are equal to each other.

6. A laminate according to Claim 5 wherein a copper foil is adhered to one or both faces of the laminate.

## Patentansprüche

1. Schichtstoff für gedruckte Schaltungen mit mehreren geschichteten Gewebeschichten und einem synthetischen Harz, das in die Gewebeschichten imprägniert ist und die Schichten damit vereinigt;
wobei das Gewebe Glasfaserkettgarne und Glasfaserschußfäden aufweist;
dadurch **gekennzeichnet,** daß
die Garne eine Zwirnzahl von 0,3 bis 3t/25 mm aufweisen; wobei die Schußfäden nur rechtsgezwirnte Garne oder nur linksgezwirnte Garne aufweisen; und daß
wenn die Glasfaserschußfäden nur rechtsgezwirnte Garne aufweisen, die Glasfaserkettgarne im wesentlichen gleichmäßig verteilte linksgezwirnte und rechtsgezwirnte Garne in einem Verhältnis im Bereich von 1/2 bis 1/8 aufweisen, und wenn die Glasfaserschußfäden nur linksgezwirnte Garne aufweisen, die Glasfaserkettgarne im wesentlichen gleichmäßig verteilte rechtsgezwirnte und linksgezwirnte Garne in einem Verhältnis im Bereich von 1/2 bis 1/8 aufweisen.

2. Schichtstoff nach Anspruch 1,
dadurch **gekennzeichnet,** daß
die Zwirnzahlen der rechtsgezwirnten Garne und der linksgezwirnten Garne, die das Kettgarn bilden, gleich sind.

3. Schichtstoff nach Anspruch 1,
dadurch **gekennzeichnet,** daß
an eine oder beide Flächen des Schichtstoffs eine Kupferfolie aufgebracht ist.

4. Schichtstoff nach Anspruch 1, der zusätzlich mehrere Schichten Vliesstoff aufweist, die gestapelt sind, wodurch wenigstens zwei der Schichten von Gewebe vorgesehen sind, von denen eine auf eine Fläche der gestapelten Schichten des Vliesstoffes und deren andere auf die andere Fläche der Schichten des Vliesstoffes gestapelt wird; und wobei ein synthetisches Harz sowohl in die Schichten des Vliesstoffes als auch die Schichten von Gewebe imprägniert wird, wodurch diese Schichten vereinigt werden.

5. Schichtstoff nach Anspruch 4,
dadurch **gekennzeichnet,** daß
die Zwirnzahlen der rechtsgezwirnten Garne und der linksgezwirnten Garne, welche die Kettgarne bilden, gleich sind.

6. Schichtstoff nach Anspruch 5,
dadurch **gekennzeichnet,** daß
eine Kupferfolie auf eine oder beide Flächen des Schichtstoffs aufgebracht ist.

## Revendications

1. Stratifié pour carte de circuit imprimé, comprenant plusieurs couches d'étoffe tissée qui sont empilées et une résine de synthèse imprégnant les couches d'étoffe tissée et rendant les couches solidaires,
l'étoffe ayant des fils de chaîne de fibres de verre et des fils de trame de fibres de verre,
caractérisé en ce que :
les fils ont un nombre de torsions compris entre 0,3 à 3 tr/25 mm, les fils de trame comprennent uniquement des fils à torsion en Z ou uniquement des fils à torsion en S, et
lorsque les fils de trame de fibres de verre ont uniquement des fils à torsion en Z, les fils de chaîne de fibres de verre comprennent des fils à torsion en S et des fils à torsion en Z dans un rapport compris entre 1/2 et 1/8, répartis de manière pratiquement uniforme, et, lorsque les fils de trame de fibres de verre comprennent uniquement des fils à torsion en S, les fils de chaîne de fibres de verre comprennent des fils à torsion en Z et des fils à torsion en S dans un rapport compris entre 1/2 et 1/8, répartis de manière pratiquement uniforme.

2. Stratifié selon la revendication 1, dans lequel les nombres de torsions des fils à torsion en Z et des fils à torsion en S constituant les fils de chaîne sont égaux.

3. Stratifié selon la revendication 1, dans lequel une feuille de cuivre adhère à une face ou aux deux faces du stratifié.

4. Stratifié selon la revendication 1, comprenant en outre plusieurs couches d'étoffe non tissée qui sont empilées, et deux couches d'étoffe tissée au moins sont présentes, l'une étant empilée sur une face des couches d'étoffe non tissée qui sont empilées et l'autre étant empilée à l'autre des faces des couches d'étoffe non tissée, et une résine de synthèse imprègne à la fois les couches d'étoffe non tissée et les couches d'étoffe tissée si bien que les couches sont solidarisées.

5. Stratifié selon la revendication 4, dans lequel les nombres de torsions des fils à torsion en Z et des fils à torsion en S constituant les fils de chaîne sont égaux.

6. Stratifié selon la revendication 5, dans lequel une feuille de cuivre adhère à une face ou aux deux faces du stratifié.
